# EUROPEAN PATENT APPLICATION

(11) **EP 3 905 332 A1**
(43) Date of publication of application: **03.11.2021**
(21) Application number: 19904584.0
(22) Date of filing: 23.12.2019
(51) Int. Cl.: H01L 27/32, H01L 51/52

(54) **DISPLAY DEVICE**

(30) Priority: 26.12.2018 KR 20180169794
(71) Applicant: Samsung Display Co., Ltd., Gyeonggi-do 17113 (KR)
(72) Inventor: SONG, Sang Hyeon, Seoul 07651 (KR); RYU, Seung-Soo, Hwaseong-si Gyeonggi-do 18476 (KR)
(74) Representative: Dr. Weitzel & Partner
(86) International application number: PCT/KR2019/018291
(87) International publication number: WO 2020/138884

(57) **Abstract**

The present disclosure relates to a display device. More particularly, the present disclosure relates to a display device for reducing a bezel area. The display device includes: a first substrate and a second substrate; a plurality of first signal lines formed on the first substrate; a plurality of second signal lines formed on the second substrate; a plurality of first lateral wires positioned on a lateral side of a first edge of the first substrate, and connected to an end portion of the first signal line; and a plurality of second lateral wires positioned on a lateral side of a second edge of the second substrate, and connected to an end portion of the second signal line, wherein the plurality of first lateral wires and the plurality of second lateral wires are disposed in at least one first region and at least one second region that are spaced from each other on the lateral sides of the first substrate and the second substrate, and the first region includes a plurality of the first lateral wires, while the second region includes a plurality of the second lateral wires.

## Description

### [Technical Field]

The present disclosure relates to a display device. More particularly, the present invention relates to a display device for reducing a bezel area.

### [Background Art]

Display devices such as a liquid crystal display (LCD) or a light emitting diode display include a display panel on which a plurality of pixels for displaying images are formed, and a driving circuit unit for driving the display panel. Each pixel includes a pixel electrode for receiving a data signal, and the pixel electrode is connected to at least one transistor to receive a data signal.

The display panel may include a display area in which a plurality of pixels are formed and a bezel area positioned near the display area and displaying no images. Various driving circuits and wires may be positioned in the bezel area.

The display device may include a touch sensing function available for interaction with a user in addition to a function for displaying images. The touch sensing function may be realized by a touch sensor formed on the display panel.

### [Detailed Description]

### [Problems to Solve]

The present invention has been made in an effort to reduce a bezel area of a display device.

### [Technical Solution]

An embodiment of the present invention provides a display device including: a first substrate and a second substrate; a plurality of first signal lines formed on the first substrate; a plurality of second signal lines formed on the second substrate; a plurality of first lateral wires positioned on a lateral side of a first edge of the first substrate, and connected to an end portion of the first signal line; and a plurality of second lateral wires positioned on a lateral side of a second edge of the second substrate, and connected to an end portion of the second signal line, wherein the plurality of first lateral wires and the plurality of second lateral wires are disposed in at least one first region and at least one second region that are spaced from each other on the lateral sides of the first substrate and the second substrate, and the first region includes a plurality of the first lateral wires, while the second region includes a plurality of the second lateral wires.

The first region may not include the second lateral wire, and the second region may not include the first lateral wire.

A plurality of access wires electrically connected to the first lateral wire and the second lateral wire may be included, a flexible printed circuit film attached to the lateral sides of the first substrate and the second substrate may be further included, and the plurality of access wires may be disposed in at least one third region corresponding to the first region and at least one fourth region corresponding to the second region.

A plurality of access wires electrically connected to the first lateral wire and the second lateral wire may be included, and a flexible printed circuit film attached to the lateral sides of the first substrate and the second substrate and a driving circuit unit positioned on the flexible printed circuit film may be further included, and the plurality of access wires may be connected to the driving circuit unit.

The plurality of first signal lines may include a plurality of data lines for transmitting data signals, and the plurality of second signal lines may include a plurality of touch signal lines for transmitting touch signals.

The first substrate may include a display area for displaying an image and a display bezel area positioned around the display area, the second substrate may include a touch region for sensing a touch and a touch bezel area positioned around the touch region peripheral, the plurality of first signal lines may include a plurality of first peripheral signal lines positioned in a first display bezel area positioned between the display area and the first edge from among the display bezel area, and the plurality of second signal lines may include a plurality of second peripheral signal lines positioned in a first touch bezel area positioned between the touch region and the second edge from among the touch bezel area.

The first peripheral signal line connected to the first lateral wire positioned on at least one border from among respective borders of the one first region may extend in a direction that is substantially perpendicular to the first edge.

A driving circuit unit positioned on the flexible printed circuit film may be further included, and the plurality of access wires may be connected to the driving circuit unit.

The second peripheral signal line may be positioned on a side of the second substrate that does not face the first substrate.

The second peripheral signal line may be positioned on a side that faces the first substrate from among the second substrate.

The plurality of second lateral wires may be positioned to gather to the one second region positioned in a center of the second edge, and the first lateral wires may be spaced from the second region and are positioned in two of the first regions facing each other with the second region therebetween.

The at least one second region may be provided as one, the plurality of second lateral wires may be positioned in the one second region positioned at one border of the second edge, the at least one first region may be provided as one, the plurality of first lateral wires may be positioned in the one first region spaced from the second region, the first substrate may include a display area for displaying an image and a display bezel area positioned around the display area, the first signal lines may include a plurality of first peripheral signal lines positioned in a first display bezel area positioned between the display area and the first edge from among the display bezel area, and the plurality of first peripheral signal lines may extend in a direction that is substantially perpendicular to the first edge.

The plurality of second lateral wires may be disposed in two of the second regions positioned near respective borders of the second edge, and the plurality of first lateral wires may be positioned in at least one of the first region positioned between the two second regions.

The plurality of second lateral wires may be disposed in at least three of the second regions that are spaced from each other, and the plurality of first lateral wires may be disposed in a plurality of the first regions which are alternately disposed with the at least three second regions.

Another embodiment of the present invention provides a display device including: a first substrate and a second substrate; a plurality of first signal lines formed on the first substrate; a plurality of second signal lines formed on the second substrate; a plurality of first lateral wires positioned on a lateral side of a first edge of the first substrate, and connected to an end portion of the first signal line; and a plurality of second lateral wires positioned on a lateral side of a second edge of the second substrate, and connected to an end portion of the second signal line, wherein the second lateral wires may be positioned in a second region positioned in a center of the second edge, and the first lateral wires may be positioned in two first regions spaced from the second region and facing each other with the second region therebetween.

Another embodiment of the present invention provides a display device including: a first substrate and a second substrate; a plurality of first signal lines formed on the first substrate; a plurality of second signal lines formed on the second substrate; a plurality of first lateral wires positioned on a lateral side of a first edge of the first substrate, and connected to an end portion of the first signal line; and a plurality of second lateral wires positioned on a lateral side of a second edge of the second substrate, and connected to an end portion of the second signal line, wherein the first signal lines may include a plurality of data lines, the first lateral wires may be disposed in at least one first region on the lateral side of the first substrate, and an end portion of the data line connected to the first lateral wire positioned on at least one border from among respective borders of the first region may extend in a direction that is substantially perpendicular to the first edge in a plan view.

The first region may not include the second lateral wire, and the second region may not include the first lateral wire.

A plurality of access wires electrically connected to the first lateral wire and the second lateral wire may be included, and a flexible printed circuit film attached to the lateral sides of the first substrate and the second substrate may be further included, and the plurality of access wires may be disposed in at least one third region corresponding to the first region and at least one fourth region corresponding to the second region.

### [Effects of Invention]

According to the embodiments of the present invention, the bezel area of the display device may be reduced.

### [Description of the Drawings]

FIG. 1 shows a perspective view of a display device according to an embodiment of the present invention.
FIG. 2 and FIG. 3 respectively show a cross-sectional view of different portions of a display device shown in FIG. 1.
FIG. 4 and FIG. 5 respectively show a cross-sectional view of different portions of a display device shown in FIG. 1.
FIG. 6 shows a cross-sectional view of a portion of a display device shown in FIG. 1.
FIG. 7 shows a top plan view of a second substrate of a display device according to an embodiment of the present invention.
FIG. 8 and FIG. 9 respectively show a top plan view of a first substrate of a display device according to an embodiment of the present invention.
FIG. 10 shows a top plan view of a second substrate of a display device according to an embodiment of the present invention.
FIG. 11 shows a top plan view of a first substrate of a display device according to an embodiment of the present invention.
FIG. 12 shows a top plan view of a second substrate of a display device according to an embodiment of the present invention.
FIG. 13 and FIG. 14 respectively show a top plan view of a first substrate of a display device according to an embodiment of the present invention.
FIG. 15 shows a top plan view of a second substrate of a display device according to an embodiment of the present invention.
FIG. 16 shows a top plan view of a first substrate of a display device according to an embodiment of the present invention.
FIG. 17 and FIG. 18 respectively show a cross-sectional view of a display device according to an embodiment of the present invention.

### [Exemplary Mode for Invention]

The present invention will be described more fully hereinafter with reference to the accompanying drawings, in which exemplary embodiments of the invention are shown. As those skilled in the art would realize, the described embodiments may be modified in various different ways, all without departing from the spirit or scope of the present invention.

Parts that are irrelevant to the description will be omitted to clearly describe the present invention, and the same elements will be designated by the same reference numerals throughout the specification.

The size and thickness of each configuration shown in the drawings are arbitrarily shown for better understanding and ease of description, but the present invention is not limited thereto. In the drawings, the thickness of layers, films, panels, regions, etc., are exaggerated for clarity. The thicknesses of some layers and areas are exaggerated for convenience of explanation.

It will be understood that when an element such as a layer, film, region, or substrate is referred to as being "on" another element, it can be directly on the other element or intervening elements may also be present. In contrast, when an element is referred to as being "directly on" another element, there are no intervening elements present. The word "on" or "above" means positioned on or below the object portion, and does not necessarily mean positioned on the upper side of the object portion based on a gravitational direction.

Unless explicitly described to the contrary, the word "comprise", and variations such as "comprises" or "comprising" will be understood to imply the inclusion of stated elements but not the exclusion of any other elements.

Throughout the specification, a plane view represents a view for observing a side that is parallel to two directions (e.g., a first direction (DR1) and a second direction (DR2)) crossing each other, and a cross-sectional view represents a view for observing a side that is cut in a direction (e.g., a third direction (DR3)) that is perpendicular to a side that is parallel to the first direction (DR1) and the second direction (DR2). Further, when two constituent elements overlap each other, it means that the two constituent elements overlap each other in the third direction (DR3), for example, in the direction that is perpendicular to an upper side of a substrate.

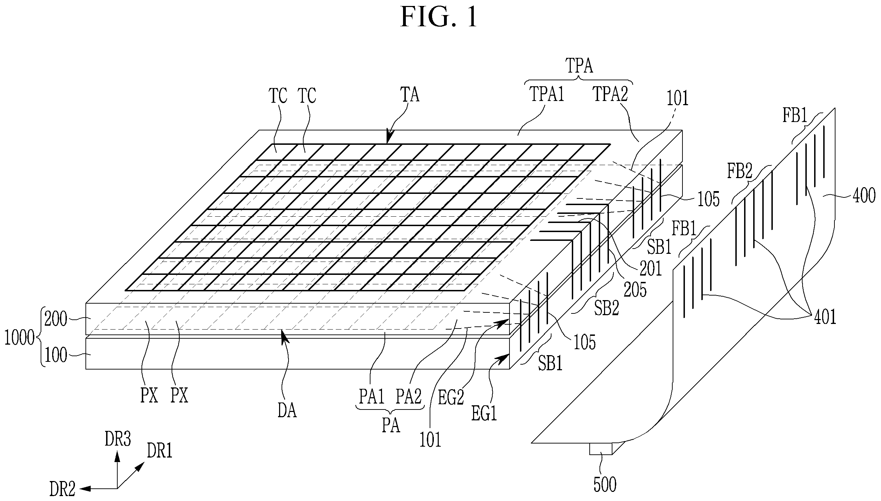

FIG. 1 shows a perspective view of a display device according to an embodiment of the present invention.

The display device includes a display panel 100 including a first substrate 100 and a second substrate 200 bonded to each other, and a flexible printed circuit (FPC) film 400. Respective principal surfaces of the first substrate 100 and the second substrate 200 are disposed in parallel with each other. The respective principal surfaces of the first substrate 100 and the second substrate 200 are illustrated in FIG. 1 to extend in the first direction (DR1) and the second direction (DR2).

The first substrate 100 and the second substrate 200 may have a fixed shape and may be flexible. The first substrate 100 and the second substrate 200 may include glass and plastic. When the first substrate 100 and the second substrate 200 are flexible, they may include various types of plastic such as polyethylene terephthalate (PET), polyethylene naphthalate (PEN), polycarbonate (PC), polyarylate (PAR), polyetherimide (PEI), polyethersulfone (PES), or polyimide (PI), a metal thin film, or very thin glass.

The first substrate 100 includes a display area (DA) for displaying images and a bezel area (PA) positioned around the display area (DA) and displaying no images.

A plurality of pixels (PX) and a plurality of signal lines are formed in the display area (DA). The pixel (PX) is a unit for displaying images, and it may include at least one pixel electrode, and may emit luminance corresponding to a gray of an input image signal. The pixel (PX) may represent a unit region for emitting light in a plan view, and it may be used to include constituent elements, such as a transistor or a light-emitting device, configured to emit light in a cross-sectional view.

In a plan view, a lower border of the display area (DA) may substantially extend in parallel with the first direction (DR1), and it is not limited thereto.

The bezel area (PA) may include a first bezel area PA1 positioned between an edge excluding one edge (EG1) of the first substrate 100 and the display area (DA), and a second bezel area (PA2) positioned between the edge (EG1) of the first substrate 100 and the display area (DA).

A plurality of signal lines may extend to the bezel area (PA), and a portion of the signal line extending to the second bezel area (PA2) will be referred to as a peripheral signal line 101. Respective peripheral signal lines 101 are electrically connected to a lateral wire 105 formed on a lateral side of the edge (EG1) of the first substrate 100. An end portion exposed at the edge (EG1) of the peripheral signal line 101 may be electrically connected to the lateral wire 105.

The lateral wire 105 may extend to a lateral side of the edge (EG2) of the second substrate 200. The edge (EG2) of the second substrate 200 is arranged in parallel with the edge (EG1) of the first substrate 100. The edge (EG1) and the edge (EG2) may substantially extend in parallel with the first direction (DR1).

The first substrate 100 on which the pixel (PX) is formed is also referred to as a display unit.

The second substrate 200 may include a touch region (TA) for sensing a touch from an outside of the display device and a touch bezel area (TPA) positioned around the touch region (TA).

A plurality of touch cells (TC) are formed in the touch region (TA). The touch cell (TC) is a unit for sensing an external touch, it includes at least one touch electrode, and it may sense the external touch with various methods such as a mutual capacitive type or a self-capacitive type and may output a touch output signal.

The touch bezel area (TPA) may include a first touch bezel area (TPA1) positioned between an edge excluding an edge (EG2) of the second substrate 200 and the touch region (TA), and a second touch bezel area (TPA2) positioned between the edge (EG2) of the second substrate 200 and the touch region (TA). In a plan view, the second touch bezel area (TPA2) may overlap the second bezel area (PA2) of the first substrate 100.

A plurality of touch signal lines connected to the touch cell (TC) may be positioned in the touch bezel area (TPA). The touch signal line may extend to the second touch bezel area (TPA2). A touch signal line portion extending to the second touch bezel area (TPA2) will be referred to as a touch peripheral signal line 201. Respective touch peripheral signal lines 201 are electrically connected to a touch lateral wire 205 formed on a lateral side of the edge (EG2) of the second substrate 200. An end portion exposed at the edge (EG2) of the touch peripheral signal line 201 may be electrically connected to the touch lateral wire 205. The touch lateral wire 205 may extend to a lateral side of the edge (EG1) of the first substrate 100.

The second substrate 200 on which the touch cell (TC) and the touch signal line are formed will also be referred to as a touch unit.

A lateral side of the edge (EG1) of the first substrate 100 and a lateral side of the edge (EG2) of the second substrate 200 may configure a planar side. The lateral side of the edge (EG1) of the first substrate 100 and the lateral side of the edge (EG2) of the second substrate 200 may extend in parallel with the third direction (DR3) as one plane, and they are not limited thereto. That is, the lateral side of the edge (EG1) of the first substrate 100 and the lateral side of the edge (EG2) of the second substrate 200 may be perpendicular to the principal surfaces of the first substrate 100 and the second substrate 200, and they are not limited thereto. The lateral side of the edge (EG1) of the first substrate 100 and the lateral side of the edge (EG2) of the second substrate 200 will also be referred to as lateral sides of the display panel of the edges (EG1 and EG2).

The lateral wire 105 and the touch lateral wire 205 formed on the lateral side of the display panel of the edges (EG1 and EG2) are disposed in a first region (SB1) and a second region (SB2) that are separated from each other and spaced from each other. That is, at least one first region (SB1) and at least one second region (SB2) may be positioned on the lateral side of the display panel of the edges (EG1 and EG2), and the first region (SB1) and the second region (SB2) may be separated from each other and may be spaced from each other. Each first region (SB1) may include a plurality of lateral wires 105 and no touch lateral wire 205, and each second region (SB2) may include a plurality of touch lateral wires 205 and no lateral wire 105. FIG. 1 illustrates an example in which one second region (SB2) is positioned between two first regions (SB1) positioned on respective borders of the lateral side of the display panel of the edges (EG1 and EG2). When the display device includes a plurality of first regions (SB1) and second regions (SB2), the first regions (SB1) and the second regions (SB2) may be alternately arranged in the second direction (DR2) as an example.

A driving circuit unit 500 is connected to a flexible printed circuit film 400, and a plurality of access wires 401 are formed on the flexible printed circuit film 400. A portion in which a plurality of access wires 401 are formed from among the flexible printed circuit film 400 may be attached to the lateral side of the display panel of the edges (EG1 and EG2) and may be electrically connected to the display panel. The flexible printed circuit film 400 excluding a portion attached to the lateral side of the display panel of the edges (EG1 and EG2) may be bent below the display panel 1000, and a driving circuit unit 500 may be positioned on one side of the flexible printed circuit film 400 positioned below the display panel 1000.

A plurality of access wires 401 may be disposed in at least one third region (FB1) and at least one fourth region (FB2) corresponding to the first region (SB1) and the second region (SB2) positioned on the lateral side of the display panel of the edges (EG1 and EG2). The third region (FB1) and the fourth region (FB2) may be separated from each other and may be spaced from each other on the flexible printed circuit film 400. Each third region (FB1) may include a plurality of access wires 401 connected corresponding to a plurality of lateral wires 105 of the display panel 1000, and each fourth region (FB2) may include a plurality of access wires 401 connected corresponding to a plurality of touch lateral wires 205 of the display panel 1000. FIG. 1 illustrates an example in which one fourth region (FB2) is positioned between two third regions (FB1) positioned on respective borders of the flexible printed circuit film 400.

A plurality of access wires 401 may extend to the driving circuit unit 500 and may be connected to the driving circuit unit 500.

The display device according to an embodiment may include a flexible printed circuit film 400 connected to a lateral side of the display panel 1000.

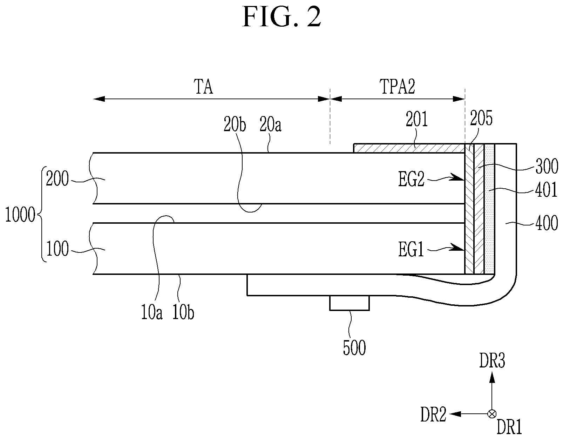

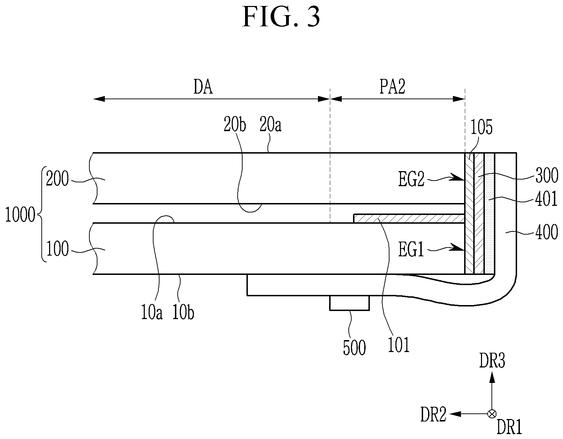

FIG. 2 and FIG. 3 respectively show a cross-sectional view of different portions of a display device shown in FIG. 1, and in detail, FIG. 2 shows a cross-sectional view of a portion in which a touch peripheral signal line 201 and a touch lateral wire 205 are positioned, and FIG. 3 shows a cross-sectional view of a position in which a peripheral signal line 101 and a lateral wire 105 are positioned.

Referring to FIG. 1, FIG. 2, and FIG. 3, a first substrate 100 includes an upper side 10a and a lower side 10b forming respective sides, and a second substrate 200 includes an upper side 20a and a lower side 20b forming respective sides. The upper side 10a of the first substrate 100 may face the lower side 20b of the second substrate 200.

The touch peripheral signal line 201 may be formed on the upper side 20a of the second substrate 200, and the peripheral signal line 101 may be formed on the upper side 10a of the first substrate 100.

The lateral wire 105 and the touch lateral wire 205 may be conductive wires including at least one metal. The touch lateral wire 205 may be connected to the touch peripheral signal line 201, and the lateral wire 105 may be connected to the peripheral signal line 101. The lateral wire 105 and the touch lateral wire 205 may further form a region between the first substrate 100 and the second substrate 200.

A conductive connector 300 may be positioned among the access wire 401 formed on the flexible printed circuit film 400, the lateral wire 105, and the touch lateral wire 205. The connector 300 may be an anisotropic conductive film (ACF) including a conductive ball, and the connector 300 may be a conductive connection electrode formed by the conductive ball. The connector 300 may electrically connect the access wire 401 of the flexible printed circuit film 400, the lateral wire 105, and the touch lateral wire 205.

The flexible printed circuit film 400 is bent below the display panel 1000, and the flexible printed circuit film 400 positioned below the display panel 1000 may be fixed to the lower side of the display panel 1000. A driving circuit unit 500 may be positioned on the lower side of the flexible printed circuit film 400 fixed to the lower side of the display panel 1000. Differing from this, the driving circuit unit 500 may be positioned between the flexible printed circuit film 400 fixed to the lower side of the display panel 1000 and the lower side 10b of the first substrate 100 of the display panel 1000.

The driving circuit unit 500 may include a display driving circuit for displaying images by driving a plurality of pixels (PX) included by the first substrate 100, that is, the display unit, and a touch driving circuit for generating contact information by inputting a signal to a plurality of touch cells (TC) included by the second substrate 200, that is, the touch unit, or receiving a touch output signal and processing the same. The driving circuit unit 500 may be realized with an IC chip including a display driving circuit and a touch driving circuit, and may include a plurality of IC chips respectively including the display driving circuit and the touch driving circuit.

Referring to FIG. 2 and FIG. 3, part of the flexible printed circuit film 400 bent at the lower corner of the first substrate 100 may be spaced from the lower side 10b of the first substrate 100 to form a space. A space between the flexible printed circuit film 400 and the lower side 10b of the first substrate 100 may be filled with air, and a buffer member with an insulation property may be positioned.

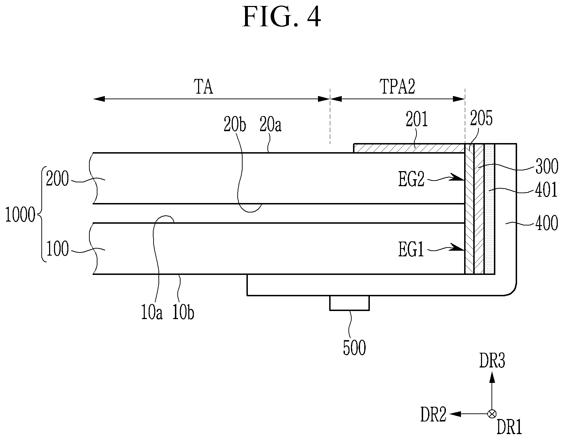

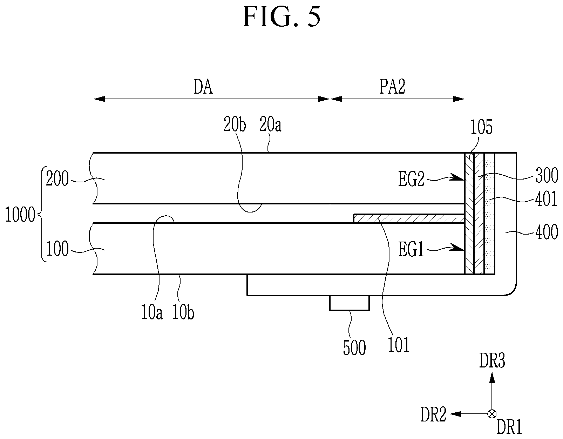

FIG. 4 and FIG. 5 respectively show a cross-sectional view of different portions of a display device shown in FIG. 1, and in detail, FIG. 4 shows a cross-sectional view of a portion in which a touch peripheral signal line 201 and a touch lateral wire 205 are positioned, and FIG. 5 shows a cross-sectional view of a portion in which a peripheral signal line 101 and a lateral wire 105 are positioned.

FIG. 4 and FIG. 5 mostly correspond to an embodiment described with reference to FIG. 2 and FIG. 3, and show an example in which there is no space between the flexible printed circuit film 400 bent at the lower corner of the first substrate 100 and the lower side 10b of the first substrate 100, and the flexible printed circuit film 400 is closely attached to the lower side 10b of the first substrate 100.

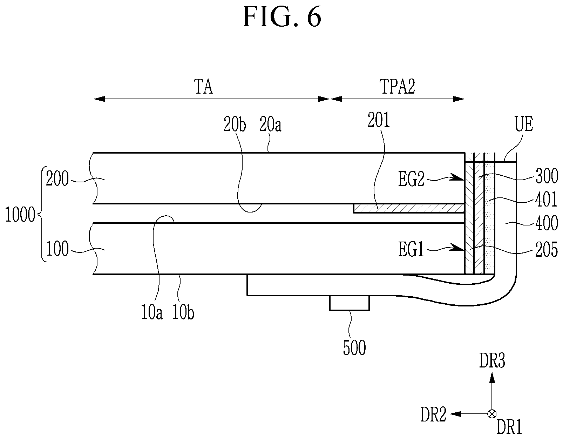

FIG. 6 shows a cross-sectional view of a portion of a display device shown in FIG. 1, and differing from an embodiment described with reference to FIG. 2, it illustrates an example in which the touch peripheral signal line 201 is formed on the lower side 20b of the second substrate 200. According to this, there is no need to form the touch lateral wire 205 up to an upper end of the lateral side of the edge (EG2) of the second substrate 200, so a length of the touch lateral wire 205 in the third direction (DR3) may be reduced. That is, as shown in FIG. 6, an upper end (UE) of the touch lateral wire 205 does not extend up to the upper side 20a of the second substrate 200 and may be positioned in a middle of the lateral side of the edge (EG2) of the second substrate 200.

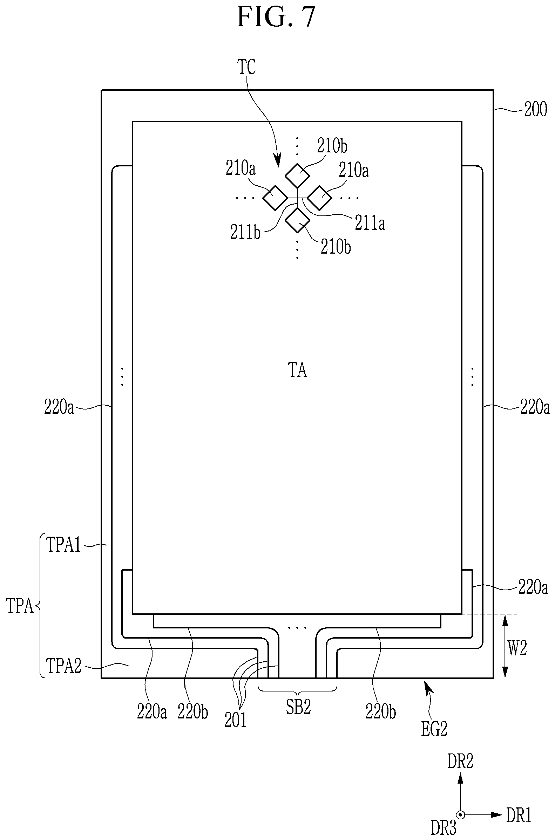

A detailed structure of a display device according to an embodiment will now be described with reference to FIG. 7 to FIG. 9 together with the above-described drawings.

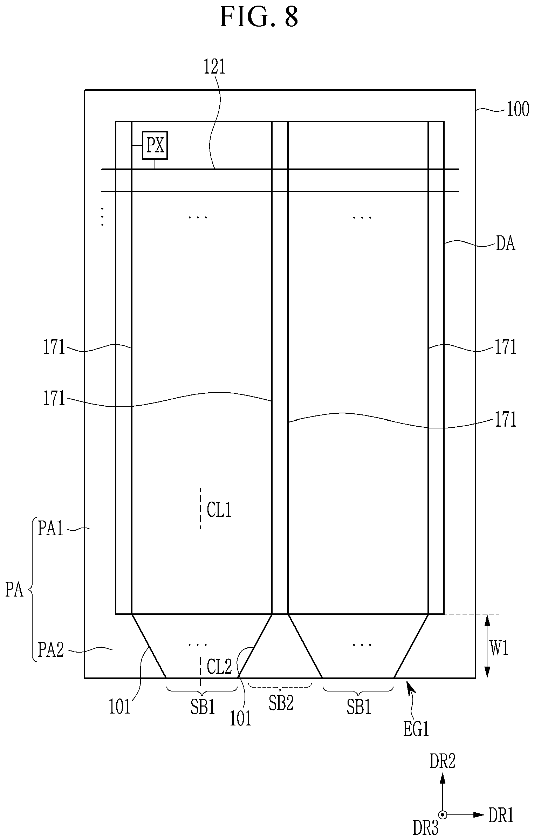

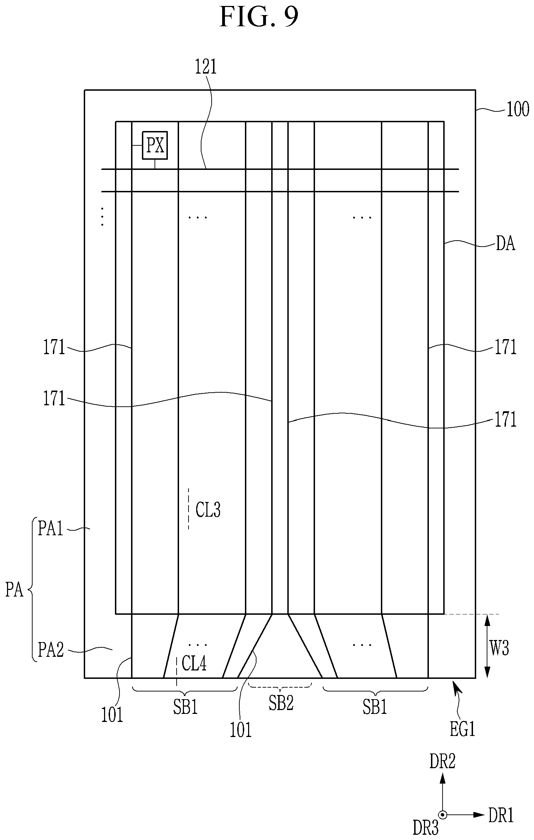

FIG. 7 shows a top plan view of a second substrate of a display device according to an embodiment of the present invention, and FIG. 8 and FIG. 9 respectively show a top plan view of a first substrate of a display device according to an embodiment of the present invention.

Referring to FIG. 7, a touch unit may include a touch region (TA) and a touch bezel area (TPA) as described above.

A plurality of first touch electrodes 210a and second touch electrodes 210b for configuring a mutual capacitive type of touch sensor may be formed in the touch region (TA) as an example of the touch cell. Two first touch electrodes 210a neighboring in the first direction (DR1) may be connected to each other with a connection line 211a, and two second touch electrodes 210b neighboring in the second direction (DR2) may be connected to each other with a connection line 211b. The connection line 211a and the connection line 211b may cross each other in an insulated way.

The first touch electrode 210a and the second touch electrode 210b neighboring each other may form a mutual sensing capacitor. One of the first touch electrode 210a and the second touch electrode 210b configuring one mutual sensing capacitor may receive a touch input signal, and may output a change of charges caused by a touch of an external object through the other touch electrode as a touch output signal.

A plurality of touch signal lines 220a and 220b may be positioned in the touch bezel area (TPA). A plurality of touch signal lines 220a and 220b may include a first touch signal line 220a connected to the first touch electrode 210a positioned on the border of the touch region (TA) and a second touch signal line 220b connected to a second touch electrode 210b positioned on the border of the touch region (TA).

The first touch signal line 220a may mainly extend in the second direction (DR2) in the first touch bezel area (TPA1) and may configure a touch peripheral signal line 201 in the second touch bezel area (TPA2).

The second touch signal line 220b may extend to the second touch bezel area (TPA2) to configure a touch peripheral signal line 201.

The touch peripheral signal line 201 of the first and second touch signal lines 220a and 220b may gather to one second region (SB2) positioned at the edge (EG2) of the second substrate 200. The touch peripheral signal line 201 may be formed up to the edge (EG2) of the second substrate 200. The second region (SB2) may be positioned substantially in a center of the edge (EG2) of the second substrate 200.

Referring to FIG. 8, the display unit may include a display area (DA) and a bezel area (PA) as described above.

A plurality of pixels (PX), and a plurality of signal lines including a plurality of scan lines 121 and a plurality of data lines 171, may be formed in the display area (DA).

A plurality of scan lines 121 may transmit gate signals. The respective scan lines 121 may substantially extend in the first direction (DR1), and a plurality of scan lines 121 may be sequentially arranged in the second direction (DR2). The scan line 121 may extend to the first bezel area PA1 and may be connected to the gate driving circuit. The gate driving circuit may be formed in the first bezel area PA1.

A plurality of data lines 171 may transmit data signals. The respective data lines 171 may substantially extend in the second direction (DR2), and a plurality of data lines 171 may be sequentially arranged in the first direction (DR1). The data line 171 may extend in the second bezel area (PA2) and may configure a peripheral signal line 101.

The peripheral signal line 101 may further include peripheral signal lines of various signal lines such as driving voltage lines in addition to the data line 171.

The peripheral signal lines 101 may gather to a plurality of first regions (SB1) positioned at the edge (EG1) of the first substrate 100. The peripheral signal lines 101 may be formed up to the edge (EG1) of the first substrate 100. In a plan view, a plurality of peripheral signal lines 101 connected to a plurality of lateral wires 105 positioned in the first region (SB1) may form a fan-out shape in which their distance becomes closer as they become nearer the edge (EG1) of the first substrate 100 in the second bezel area (PA2). By this, a sufficient space may be obtained between the two first regions (SB1) spaced from each other at the edge (EG1) of the first substrate 100. The second region (SB2) shown in above-described FIG. 7 may be positioned between the two first regions (SB1) spaced from each other in a plan view. Therefore, in a plan view, the first region (SB1) and the second region (SB2) may not overlap each other and may be separated from each other.

In an embodiment described with reference to FIG. 8, a center line (CL2) of the first region (SB1) in the first direction (DR1) may be arranged in the second direction (DR2) with a center line (CL1) of a portion of the display area (DA) in which the data line 171 to which a peripheral signal line 101 corresponding to the first region (SB1) is connected is positioned in the first direction (DR1), or they may be provided near each other.

Most of the touch region (TA) of the touch unit may correspond to the display area (DA) of the display unit and may overlap the same.

A width W1 of the second bezel area (PA2) of the display unit in the second direction (DR2) may be equal to or different from a width W2 of the second touch bezel area (TPA2) of the touch unit in the second direction (DR2).

FIG. 9 mostly corresponds to an embodiment described with reference to FIG. 8, but a structure of the peripheral signal line 101 and a position of the first region (SB1) may be different in the second bezel area (PA2). In detail, a center line (CL4) of the first region (SB1) in the first direction (DR1) may be positioned farther from the second region (SB2) than the center line (CL2) of the first region (SB1) in the first direction (DR1) corresponding to an embodiment described with reference to FIG. 8. By this, a gap between the first region (SB1) and the second region (SB2) neighboring each other may be further increased. According to the present embodiment, the center line (CL4) of the first region (SB1) in the first direction (DR1) may not correspond to a center line (CL3) of the display area (DA) in the first direction (DR1) in which a data line 171 to which a peripheral signal line 101 is connected is positioned corresponding to the corresponding first region (SB1).

From among the peripheral signal line 101 connected to the lateral wire 105 included by each first region (SB1), the peripheral signal line 101 positioned on at least one of respective borders of the corresponding first region (SB1) may substantially extend in parallel with the second direction (DR2) in a plan view. That is, from among the peripheral signal line 101 connected to the lateral wire 105 included by each first region (SB1), the peripheral signal line 101 positioned on at least one of respective borders of the corresponding first region (SB1) may extend in direction that is substantially perpendicular to a lower border of the display area (DA) or the edge (EG1).

In detail, from among the peripheral signal line 101 connected to the lateral wire 105 included by each first region (SB1), the peripheral signal line 101 positioned farthest from the second region (SB2) may extend substantially in parallel with the second direction (DR2), and the peripheral signal line 101 positioned the nearest the second region (SB2) may be inclined to be distant from the second region (SB2) as it becomes closer to the edge (EG1). According to this, the width of each first region (SB1) in the first direction (DR1) may be greater than the width of each first region (SB1) in the first direction (DR1) in an embodiment described with reference to FIG. 8. Instead of this, according to the present embodiment, the width (W3) of the second bezel area (PA2) of the display unit in the second direction (DR2) may be less than the width (W1) of the second bezel area (PA2) in the second direction (DR2) according to an embodiment described with reference to FIG. 8.

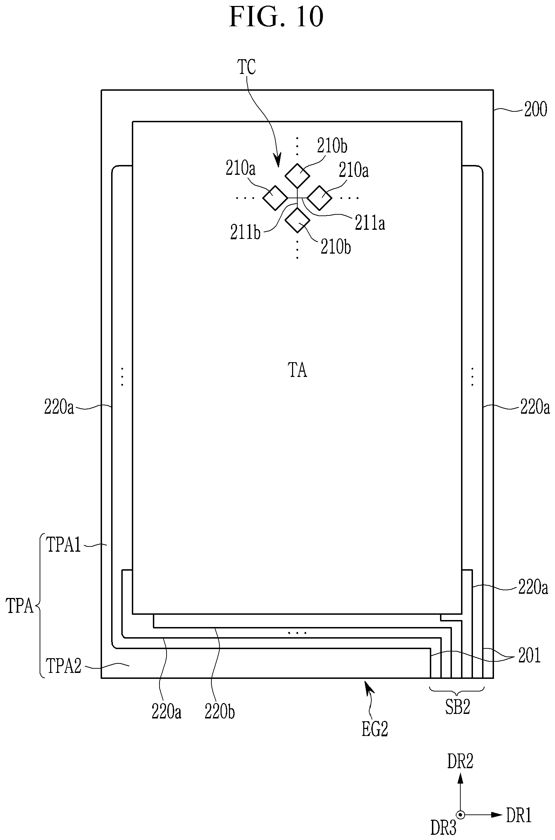

A display device according to various embodiments including a first region (SB1) and a second region (SB2) with various positions and structures will now be described with reference to FIG. 10 to FIG. 16 together with the above-described drawings.

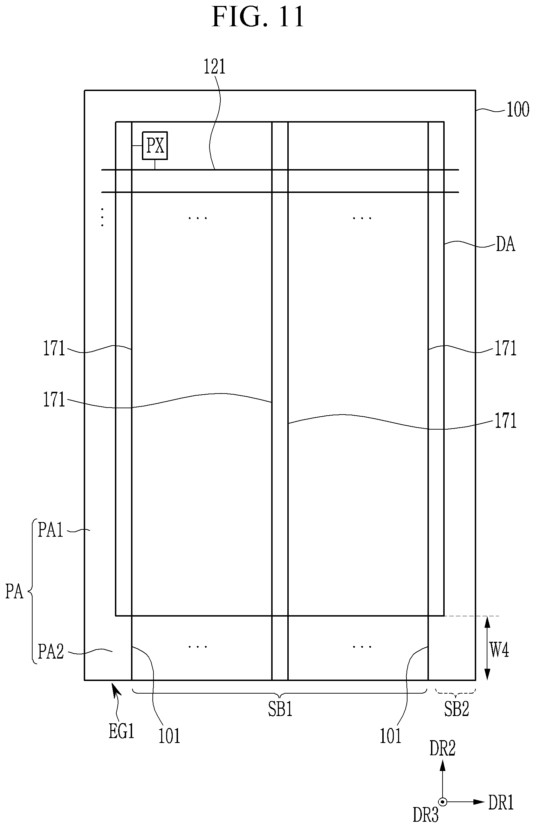

FIG. 10 shows a top plan view of a second substrate of a display device according to an embodiment of the present invention, and FIG. 11 shows a top plan view of a first substrate of a display device according to an embodiment of the present invention.

Referring to FIG. 10, a touch unit according to an embodiment, that is, the second substrate 200, mostly corresponds to the embodiment described with reference to FIG. 7, and the second region (SB2) may be positioned near a border of a left side or a right side of the edge (EG2).

Referring to FIG. 11, a display unit according to an embodiment, that is, the first substrate 100, mostly corresponds to the embodiment described with reference to FIG. 8, and one continuous first region (SB1) may occupy a majority of the edge (EG1). A width of the first region (SB1) in the first direction (DR1) may be greater than a width of the second region (SB2) in the first direction (DR1).

A plurality of peripheral signal lines 101 connected to the lateral wire 105 included by the first region (SB1) may extend substantially in parallel with the second direction (DR2) in the second bezel area (PA2). According to this, the width of each first region (SB1) in the first direction (DR1) may be greater than a width of each first region (SB1) in the first direction (DR1) in an embodiment described with reference to FIG. 9. Instead of this, according to the present embodiment, the width (W4) of the second bezel area (PA2) of the display unit in the second direction (DR2) may be less than the width (W3) of the second bezel area (PA2) in the second direction (DR2) in an embodiment described with reference to FIG. 9.

Referring to FIG. 10 and FIG. 11, the second region (SB2) is positioned on a right or left border in a plan view, so the first region (SB1) and the second region (SB2) may not overlap each other but may be separated from each other, and the peripheral signal line 101 does not configure the above-noted fan-out shape in the second bezel area (PA2), so the width of the second bezel area (PA2) in the second direction (DR2) may be further reduced.

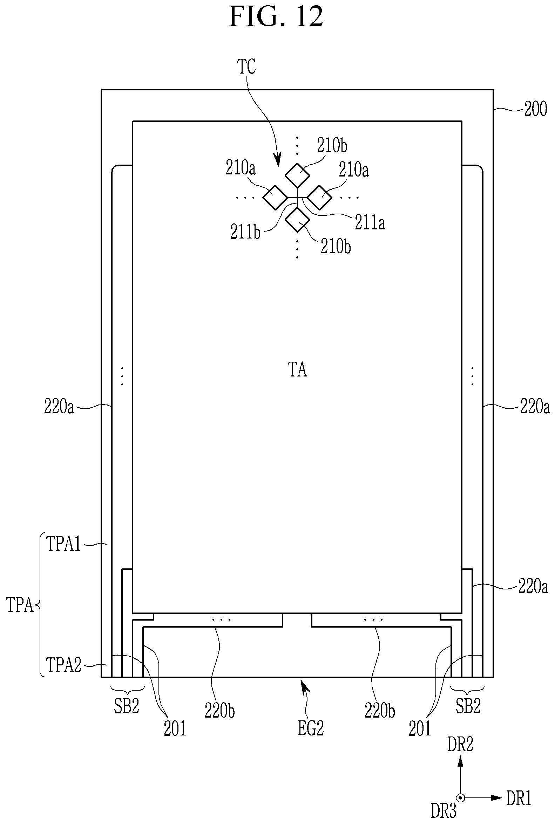

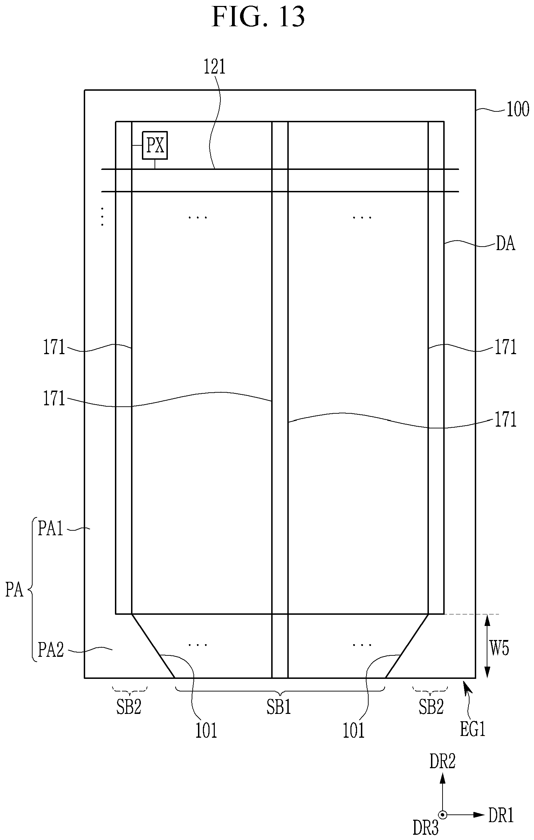

FIG. 12 shows a top plan view of a second substrate of a display device according to an embodiment of the present invention, and FIG. 13 show a top plan view of a first substrate of a display device according to an embodiment of the present invention.

Referring to FIG. 12 and FIG. 13, a first region (SB1) may be positioned between two second regions (SB2) positioned on respective borders of the lateral side of the display panel of the edges (EG1 and EG2) in a display device according to an embodiment.

Referring to FIG. 12, a touch unit according to an embodiment, that is, the second substrate 200, mostly corresponds to the embodiment described with reference to FIG. 7, but two second regions (SB2) may be positioned on the right and left borders of the edge (EG2). The left second region (SB2) may include touch peripheral signal lines 201 of a first touch signal line 220a connected to the left of the touch region (TA) and a second touch signal line 220b connected to a left half portion of the touch region (TA). The right second region (SB2) may include touch peripheral signal lines 201 of a first touch signal line 220a connected to the right of the touch region (TA) and a second touch signal line 220b connected to a right half portion at a lower end of the touch region (TA). The width of each second region (SB2) in the first direction (DR1) according to the present embodiment may be less than the width of each second region (SB2) in the first direction (DR1) according to an embodiment described with reference to FIG. 7 or FIG. 10.

Referring to FIG. 13, a display unit according to an embodiment, that is, the first substrate 100, mostly corresponds to the embodiment described with reference to FIG. 8, but the peripheral signal line 101 of the entire data line 171 may gather toward one continuous first region (SB1). That is, the peripheral signal line 101 may gather to a first region (SB1) positioned near the edge (EG1) of the first substrate 100. A plurality of peripheral signal lines 101 may have a fan-out shape in which the distance becomes closer as they become nearer the edge (EG1) of the first substrate 100 in the second bezel area (PA2). The peripheral signal line 101 of the data line 171 substantially positioned in the center of the display area (DA) may extend in parallel with the second direction (DR2) in the second bezel area (PA2).

The first region (SB1) is positioned between the two second regions (SB2) spaced from each other in a plan view, so the first region (SB1) and the second region (SB2) may not overlap each other and may be separated from each other.

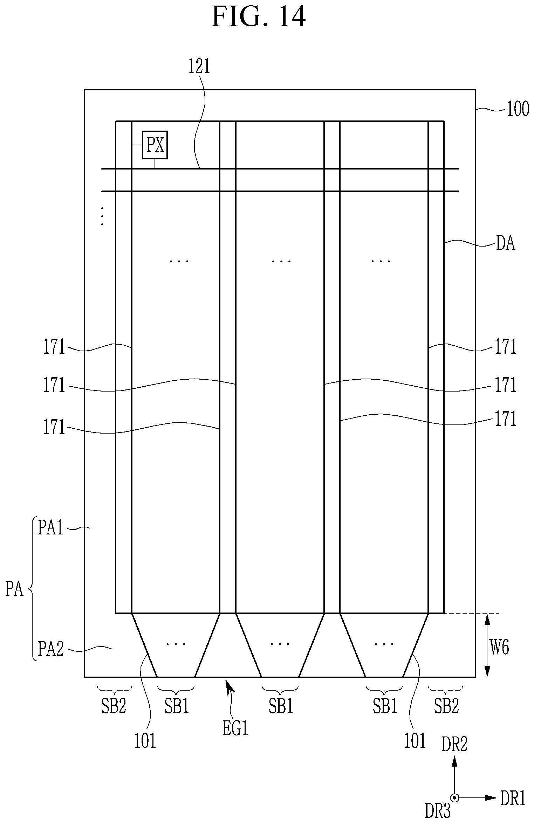

FIG. 14 shows a top plan view of a first substrate of a display device according to an embodiment of the present invention.

Referring to FIG. 14, the display device according to an embodiment mostly corresponds to the embodiment described with reference to FIG. 12 and FIG. 13, but the shape and the position of the display unit, that is, the first region (SB1) of the first substrate 100, may be different.

Differing from what is described with reference to FIG. 13, a plurality of peripheral signal lines 101 may be disposed as groups corresponding to a plurality of first regions (SB1) in the second bezel area (PA2). As shown in FIG. 1, in a plan view, a plurality of first regions (SB1) may be positioned between the two second regions (SB2) positioned on respective borders of the lateral side of the display panel of the edges (EG1 and EG2). A plurality of peripheral signal lines 101 connected to the lateral wire 105 included by each first region (SB1) may form a fan-out shape in which the distance becomes closer as they become nearer the edge (EG1) of the first substrate 100 in a plan view.

According to an embodiment described with reference to FIG. 14, a plurality of peripheral signal lines 101 are disposed to respectively have a fan-out shape at points where they correspond to a plurality of first regions (SB1) in the second bezel area (PA2), so the width of the second bezel area (PA2) in the second direction (DR2) may be further reduced, compared to the embodiment described with reference to FIG. 13. That is, in an embodiment described with reference to FIG. 14, a width (W6) of the second bezel area (PA2) in the second direction (DR2) may be less than a width (W5) of the second bezel area (PA2) in the second direction (DR2) in an embodiment described with reference to FIG. 13.

In a plan view, a plurality of first regions (SB1) are positioned between the two second regions (SB2) spaced from each other, so the first region (SB1) and the second region (SB2) may not overlap each other and may be separated from each other.

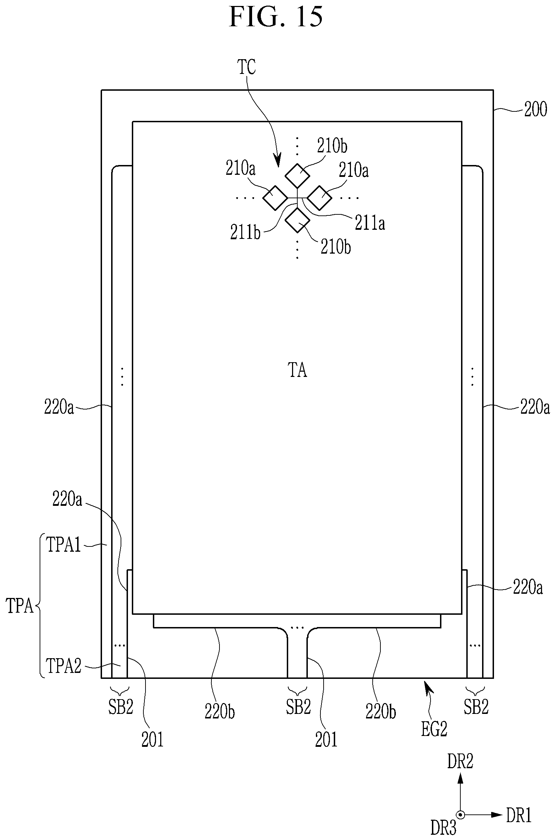

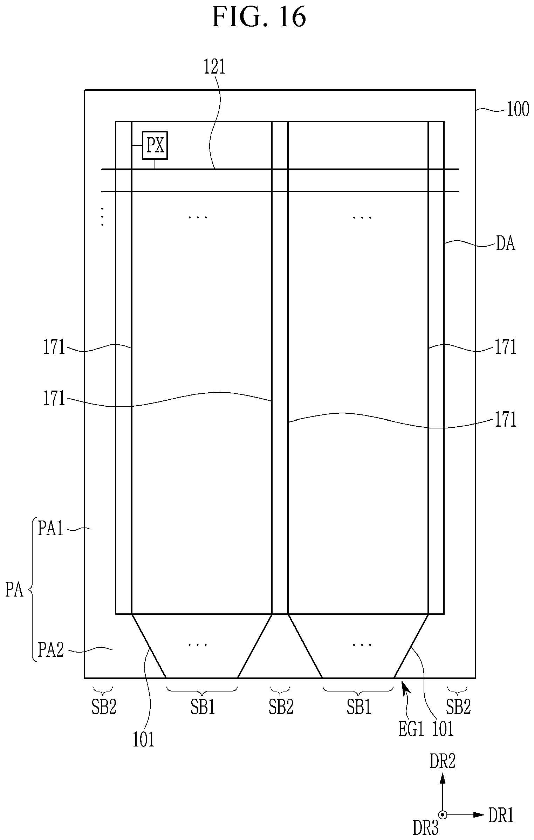

FIG. 15 shows a top plan view of a second substrate of a display device according to an embodiment of the present invention, and FIG. 16 shows a top plan view of a first substrate of a display device according to an embodiment of the present invention.

Referring to FIG. 15 and FIG. 16, a plurality of first regions (SB1) and a plurality of second regions (SB2) may be positioned on the lateral side of the display panel of the edges (EG1 and EG2) in a display device according to an embodiment. In a plan view, the first region (SB1) and the second region (SB2) may be alternately arranged in the first direction (DR1).

Referring to FIG. 15, three second regions (SB2) spaced from each other may be arranged along the edge (EG2) on the touch unit according to an embodiment, that is, the second substrate 200. The touch lateral wire 205 included by the second region (SB2) on the left side may be connected to the touch peripheral signal line 201 of the first touch signal line 220a connected to the left side of the touch region (TA), the touch lateral wire 205 included by the second region (SB2) positioned in the center may be connected to the touch peripheral signal line 201 of the second touch signal line 220b connected to the lower end of the touch region (TA), and the touch lateral wire 205 included by the second region (SB2) on the right side may be connected to the touch peripheral signal line 201 of the first touch signal line 220a connected to the right side of the touch region (TA). The width of each second region (SB2) in the first direction (DR1) according to the present embodiment may be less than the width of each second region (SB2) in the first direction (DR1) according to an embodiment described with reference to FIG. 12.

Referring to FIG. 16, a display unit according to an embodiment, that is, the first substrate 100, may correspond to the embodiment described with reference to FIG. 8. That is, the peripheral signal line 101 may be disposed corresponding to a plurality of first regions (SB1) positioned at the edge (EG1) of the first substrate 100. In a plan view, a plurality of peripheral signal lines 101 connected to a plurality of lateral wires 105 included by each first region (SB1) may have a fan-out shape in which the distance becomes closer as they become nearer the edge (EG1) of the first substrate 100 in the second bezel area (PA2).

A first region (SB1) may be positioned between two second regions (SB2) spaced from each other in a plan view. Therefore, the first region (SB1) and the second region (SB2) may not overlap each other and may be separated from each other in a plan view.

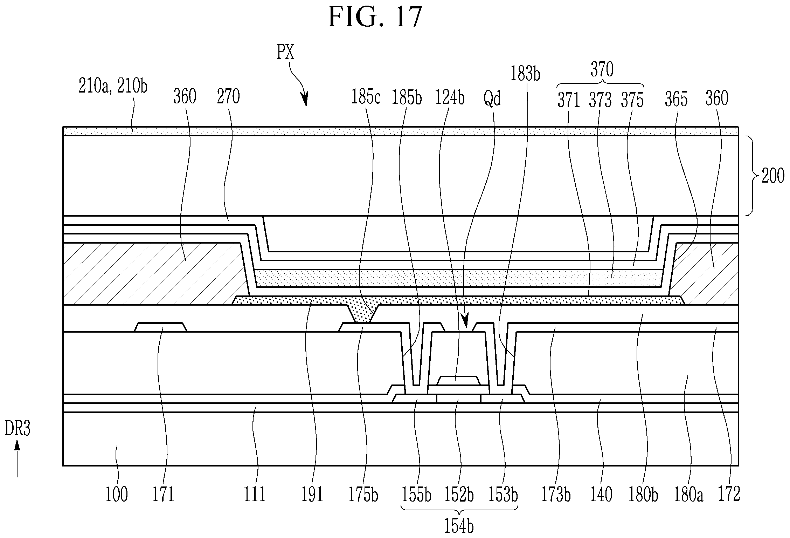

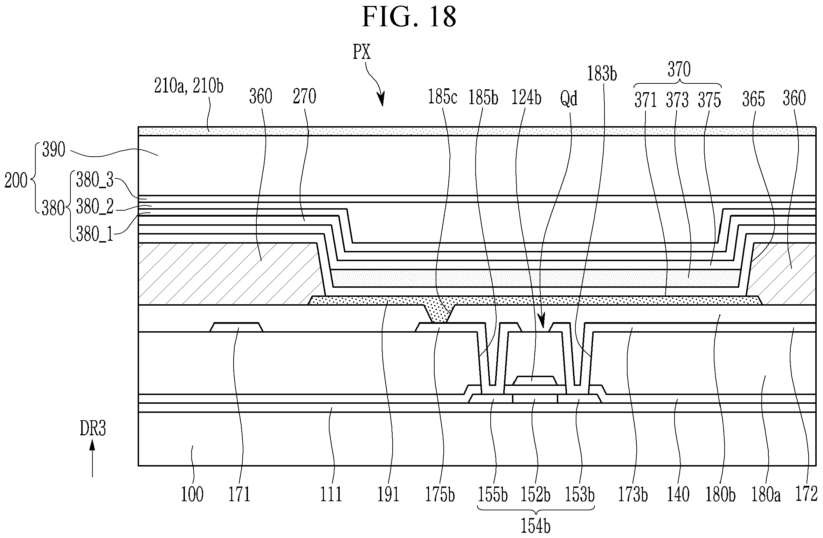

A cross-sectional structure of a display device according to an embodiment will now be described with reference to FIG. 17 and FIG. 18 together with the above-described drawings.

FIG. 17 and FIG. 18 respectively show a cross-sectional view of a pixel of a display device according to an embodiment of the present invention.

Referring to FIG. 17, the display device according to an embodiment may be an emissive display device.

A barrier layer 111 including an insulating material may be positioned on the first substrate 100. The barrier layer 111 may prevent external impurities from passing through the first substrate 100 and penetrating to an upper side. The barrier layer 111 may be omitted.

A semiconductor layer 154b including a channel region 152b, and a source region 153b and a drain region 155b positioned on respective sides of the channel region 152b and formed to be doped, may be positioned on the barrier layer 111. The semiconductor layer 154b may include amorphous silicon, polysilicon, or a metal oxide.

A gate insulating layer 140 including an inorganic insulating material may be positioned on the semiconductor layer 154b.

A gate conductive layer including a gate electrode 124b may be positioned on the gate insulating layer 140. The gate conductive layer may include a plurality of scan lines 121 that are described above. The gate electrode 124b may overlap the channel region 152b.

An inter-layer insulating layer 180a may be positioned on the gate conductive layer. The inter-layer insulating layer 180a and the gate insulating layer 140 may include contact holes 183b and 185b positioned in the source region 153b and the drain region 155b of the semiconductor layer 154b.

A plurality of data conductive layers including a plurality of data lines 171, a plurality of input electrodes 173b, and a plurality of output electrodes 175b may be positioned on the inter-layer insulating layer 180a. The input electrode 173b may be connected to the data line 171, and the output electrode 175b may be separated from the data line 171. The input electrode 173b and the output electrode 175b may be electrically connected to the source region 153b and the drain region 155b of the semiconductor layer 154b through the contact holes 183b and 185b.

The gate electrode 124b, the channel region 152b, the source region 153b, and the drain region 155b may configure a driving thin film transistor (Qd).

A passivation layer 180b including an insulating material may be positioned on the data conductive layer. The passivation layer 180b may have a contact hole 185c positioned on the output electrode 175b.

A plurality of pixel electrodes 191 may be positioned on the passivation layer 180b. The pixel electrode 191 of each pixel (PX) is electrically connected to the output electrode 175b through the contact hole 185c of the passivation layer 180b. The pixel electrode 191 may include a semi-transmitting conductive material or a reflective conductive material.

An insulating layer 360 including an opening 365 positioned on the pixel electrode 191 may be positioned on the passivation layer 180b.

A light-emitting member 370 may be positioned on the insulating layer 360 and the pixel electrode 191. The light-emitting member 370 may include a first common layer 371, an emission layer 373, and a second common layer 375 sequentially stacked from the bottom. The first common layer 371 may, for example, include a hole injecting layer and a hole transport layer. The emission layer 373 may be positioned on the pixel electrode 191 of the corresponding pixel (PX). The emission layer 373 may include an organic or inorganic material for uniquely emitting light of primary colors such as red, green, and blue, and may have a structure including a plurality of light emitting material layers for outputting light of different colors. The second common layer 375 may, for example, include an electron transport layer and an electron injecting layer. At least one of the first and second common layers 371 and 375 may be omitted.

A common electrode 270 for transmitting a common voltage may be positioned on the light-emitting member 370.

The pixel electrode 191, the light-emitting member 370, and the common electrode 270 of each pixel (PX) configure a light-emitting device, and one of the pixel electrode 191 and the common electrode 270 becomes a cathode and the other becomes an anode.

A second substrate 200 may be positioned on the common electrode 270. The second substrate 200 may prevent moisture and/or oxygen from permeating from the outside by encapsulating the light-emitting member 370 and the common electrode 270.

The constituent elements positioned between the first substrate 100 and the second substrate 200 may configure the above-described pixel (PX).

A touch conductive layer including a plurality of touch electrodes 210a and 210b and a plurality of touch signal lines may be positioned on the second substrate 200.

Referring to FIG. 18, the display device according to the present embodiment mostly corresponds to the embodiment described with reference to FIG. 17, but the second substrate 200 may be different.

The second substrate 200 according to the present embodiment may include a plurality of insulating layers 380_1, 380_2, 380_3, and 390. A plurality of insulating layers 380_1, 380_2, 380_3, and 390 may include at least two inorganic layers 380_1 and 380_3, and at least one organic layer 380_2 positioned between the two neighboring inorganic layers 380_1 and 380_3. The inorganic layers 380_1 and 380_3 may include an inorganic material such as an aluminum oxide (AlOx), a silicon oxide (SiOx), and a silicon nitride (SiNx), and the organic layer 380_2 may include an organic material and may have a substantially planar upper side.

The insulating layer 390 may include an organic material and may have a substantially planar upper side. The insulating layer 390 may be omitted.

According to various embodiments of the present disclosure, the flexible printed circuit film does not need to access the peripheral signal line 101 and the touch peripheral signal line 201 on the respective upper sides 10a and 20a of the first substrate 100 and the second substrate 200 of the display device, thereby further reducing areas of the second bezel area (PA2) and the second touch bezel area (TPA2). Further, the touch unit and the display unit may be driven by using the driving circuit unit 500 configurable with one flexible printed circuit film 400 and one IC chip, thereby further reducing the manufacturing cost.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. A display device comprising:
a first substrate and a second substrate;
a plurality of first signal lines formed on the first substrate;
a plurality of second signal lines formed on the second substrate;
a plurality of first lateral wires positioned on a lateral side of a first edge of the first substrate, and connected to an end portion of the first signal line; and
a plurality of second lateral wires positioned on a lateral side of a second edge of the second substrate, and connected to an end portion of the second signal line,
wherein the plurality of first lateral wires and the plurality of second lateral wires are disposed in at least one first region and at least one second region that are spaced from each other on the lateral sides of the first substrate and the second substrate, and
the first region includes a plurality of the first lateral wires, while the second region includes a plurality of the second lateral wires.

2. The display device of claim 1, wherein
the first region does not include the second lateral wire, and the second region does not include the first lateral wire.

3. The display device of claim 2, wherein
a plurality of access wires electrically connected to the first lateral wire and the second lateral wire are included, a flexible printed circuit film attached to the lateral sides of the first substrate and the second substrate is further included, and
the plurality of access wires are disposed in at least one third region corresponding to the first region and at least one fourth region corresponding to the second region.

4. The display device of claim 3, further comprising
a driving circuit unit positioned on the flexible printed circuit film,
wherein the plurality of access wires are connected to the driving circuit unit.

5. The display device of claim 4, wherein
the plurality of first signal lines include a plurality of data lines for transmitting data signals, and
the plurality of second signal lines include a plurality of touch signal lines for transmitting touch signals.

6. The display device of claim 1, wherein
the first substrate includes a display area for displaying an image and a display bezel area positioned around the display area,
the second substrate includes a touch region for sensing a touch and a touch bezel area positioned around the touch region peripheral,
the plurality of first signal lines include a plurality of first peripheral signal lines positioned in a first display bezel area positioned between the display area and the first edge from among the display bezel area, and
the plurality of second signal lines include a plurality of second peripheral signal lines positioned in a first touch bezel area positioned between the touch region and the second edge from among the touch bezel area.

7. The display device of claim 6, wherein
the first peripheral signal line connected to the first lateral wire positioned on at least one border from among respective borders of the one first region extends in a direction that is substantially perpendicular to the first edge.

8. The display device of claim 6, wherein
a plurality of access wires electrically connected to the first lateral wire and the second lateral wire are included, and a flexible printed circuit film attached to the lateral sides of the first substrate and the second substrate, and a driving circuit unit positioned on the flexible printed circuit film are further included, and
the plurality of access wires are connected to the driving circuit unit.

9. The display device of claim 6, wherein
the second peripheral signal line is positioned on a side of the second substrate that does not face the first substrate .

10. The display device of claim 6, wherein
the second peripheral signal line is positioned on a side that faces the first substrate from among the second substrate.

11. The display device of claim 1, wherein
the plurality of second lateral wires are positioned to gather to the one second region positioned in a center of the second edge, and
the first lateral wires are spaced from the second region and are positioned in two of the first regions facing each other with the second region therebetween.

12. The display device of claim 1, wherein
the at least one second region is provided as one, the plurality of second lateral wires are positioned in the one second region positioned at one border of the second edge,
the at least one first region is provided as one, the plurality of first lateral wires are positioned in the one first region spaced from the second region,
the first substrate includes a display area for displaying an image, and a display bezel area positioned around the display area,
the first signal lines include a plurality of first peripheral signal lines positioned in a first display bezel area positioned between the display area and the first edge from among the display bezel area, and
the plurality of first peripheral signal lines extend in a direction that is substantially perpendicular to the first edge.

13. The display device of claim 1, wherein
the plurality of second lateral wires are disposed in two of the second regions positioned near respective borders of the second edge, and
the plurality of first lateral wires are positioned in at least one of the first region positioned between the two second regions.

14. The display device of claim 1, wherein
the plurality of second lateral wires are disposed in at least three of the second regions that are spaced from each other, and
the plurality of first lateral wires are disposed in a plurality of the first regions which are alternately disposed with the at least three second regions.

15. A display device comprising:
a first substrate and a second substrate;
a plurality of first signal lines formed on the first substrate;
a plurality of second signal lines formed on the second substrate;
a plurality of first lateral wires positioned on a lateral side of a first edge of the first substrate, and connected to an end portion of the first signal line; and
a plurality of second lateral wires positioned on a lateral side of a second edge of the second substrate, and connected to an end portion of the second signal line,
wherein the second lateral wires are positioned in a second region positioned in a center of the second edge, and
the first lateral wires are positioned in two first regions spaced from the second region and facing each other with the second region therebetween.

16. The display device of claim 15, wherein
the first region does not include the second lateral wire, and the second region does not include the first lateral wire.

17. The display device of claim 16, wherein
a plurality of access wires electrically connected to the first lateral wire and the second lateral wire are included, and a flexible printed circuit film attached to the lateral sides of the first substrate and the second substrate is further included, and
the access wires are disposed in at least one third region corresponding to the first region and at least one fourth region corresponding to the second region.

18. A display device comprising:
a first substrate and a second substrate;
a plurality of first signal lines formed on the first substrate;
a plurality of second signal lines formed on the second substrate;
a plurality of first lateral wires positioned on a lateral side of a first edge of the first substrate, and connected to an end portion of the first signal line; and
a plurality of second lateral wires positioned on a lateral side of a second edge of the second substrate, and connected to an end portion of the second signal line,
wherein the first signal lines include a plurality of data lines,
the first lateral wires are disposed in at least one first region on the lateral side of the first substrate, and
an end portion of the data line connected to the first lateral wire positioned on at least one border from among respective borders of the first region extend in a direction that is substantially perpendicular to the first edge in a plan view.

19. The display device of claim 18, wherein
the first region does not include the second lateral wire, and the second region does not include the first lateral wire.

20. The display device of claim 19, wherein
a plurality of access wires electrically connected to the first lateral wire and the second lateral wire are included, and a flexible printed circuit film attached to the lateral sides of the first substrate and the second substrate is further included, and
the plurality of access wires are disposed in at least one third region corresponding to the first region and at least one fourth region corresponding to the second region.
